(19) **Europäisches Patentamt / European Patent Office / Office européen des brevets**

(11) **EP 1 703 636 B1**

(12) **EUROPEAN PATENT SPECIFICATION**

(45) Date of publication and mention
of the grant of the patent:
**19.11.2008 Bulletin 2008/47**

(51) Int Cl.:
***H03H 17/06*** [(2006.01)]

(21) Application number: **04820168.5**

(86) International application number:
**PCT/JP2004/018054**

(22) Date of filing: **03.12.2004**

(87) International publication number:
**WO 2005/057785 (23.06.2005 Gazette 2005/25)**

(54) **FIR FILTER**

FIR-FILTER

FILTRE FIR

(84) Designated Contracting States:
**DE FR GB IT**

(30) Priority: **09.12.2003 JP 2003411068**

(43) Date of publication of application:
**20.09.2006 Bulletin 2006/38**

(73) Proprietor: **National Institute of Advanced
Industrial Science
and Technology
Tokyo 100-8921 (JP)**

(72) Inventors:
• **TAKAHASHI, Eiichi,
Nat. Ins. of Adv.Ind. Sci.&Tec.
Tsukuba-shi,
Ibaraki 305-8568 (JP)**

• **HIGUCHI, Tetsuya,
Nat. Ins. of Adv. Ind. Sci.&Tec.
Tsukuba-shi,
Ibaraki 305-8568 (JP)**

(74) Representative: **Laufhütte, Dieter et al
Lorenz-Seidler-Gossel
Widenmayerstrasse 23
80538 München (DE)**

(56) References cited:
**EP-A- 0 948 133      JP-A- 5 075 394
JP-A- 57 208 722      JP-A- 60 015 769**

## Description

Technical field

The present invention relates to an FIR filter allowing high-speed operation and flexible configuration.

Background Art

A filter is an indispensable circuit element in signal processing and is the most frequently appearing and most important circuit in digital signal processing. There are two ways to configuring a digital filter, an FIR (Finite Impulse Response) filter and an IIR (Infinite Impulse Response) filter, but the FIR filter which enables a constantly stable characteristic is easier to use (for example, refer to Japanese Patent Application Lied-open No.103,418/1984). Another example is disclosed in the document EP-A-0 948 133.

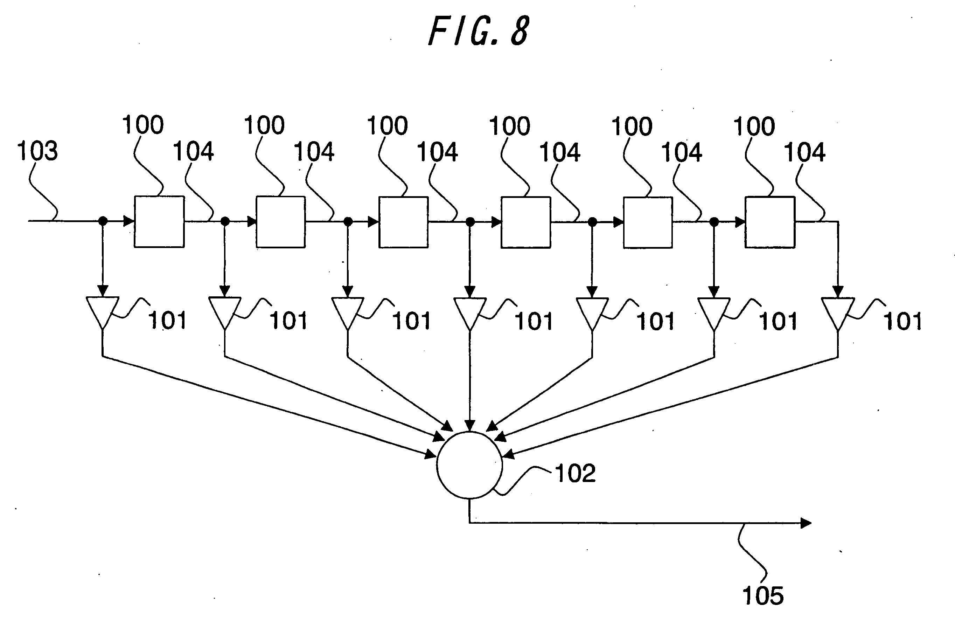

Fig.8 shows an example of a direct form structure, which is one of the most common configurations. In Fig.8, the reference numeral 100 indicates a delay circuit as an input-delay circuit, where the delay circuit 100 merely delays the input data by 1 clock cycle in order to pass it on to the next stage. The reference numeral 101 shows a multiplier as a multiplication circuit, and 102 shows an adder. In this configuration, the data-fetch circuits before and after the delay circuit 100 are called "tap", and the number of multipliers 101 connected alongside each other to the data-fetch circuits are called "number of taps", hence Fig.8 is an example of a 7-tap configured FIR filter. The reference numeral 103 indicates an input signal (filter - input data), 104 indicates an input data which is output from the delay circuit 100, then passed on to the succeeding taps and the other delay circuits 100, 105 indicates an output signal (filter-output data).

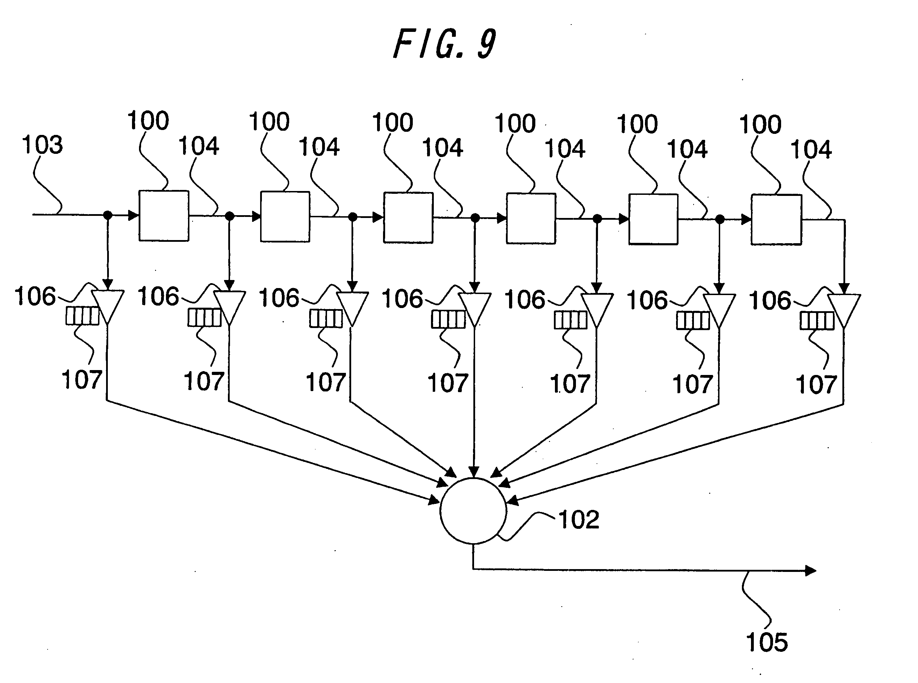

Fig.9 is an example of a circuit of an adaptive digital filter in which the coefficient of the multiplier is made variable for enabling the arbitrary setting of the filter characteristic in a common configuration of the FIR filter as shown in Fig.8, and the reference numeral 106 indicates a multiplier of variable coefficient-type, 107 indicates a memory which stores the coefficients.

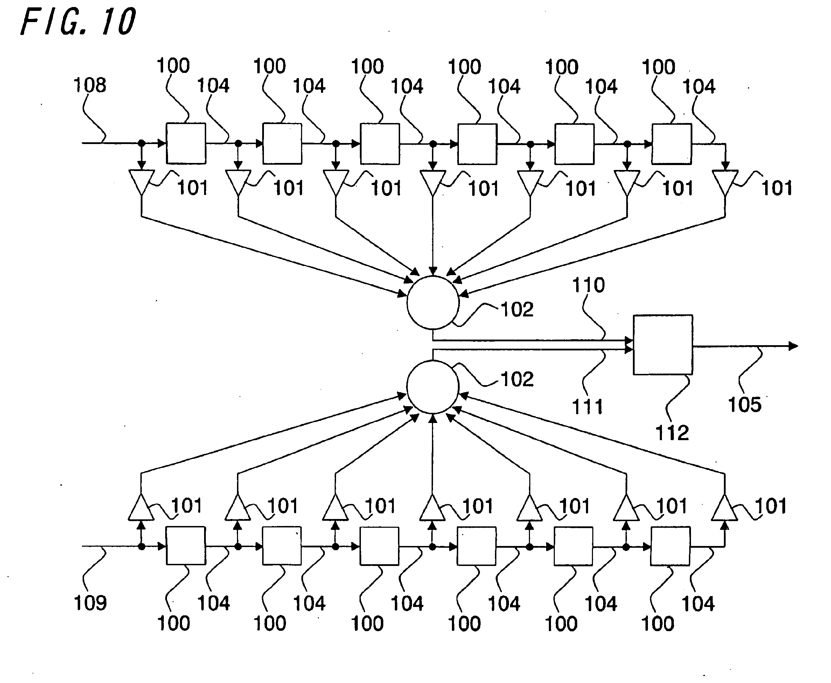

Fig.10 is an example of an FIR filter circuit in which the bit-length is made variable by adopting the bit-slice configuration. In this example, the input data is separated into two bit groups, the higher-bit group 108, and the lower-bit group 109, and at the same time, a plurality of delay circuits 100 and their corresponding multipliers 101 and adders 102 are separated into two groups (upper and lower), for example, if the groups were capable of 12-bit processing each, 24-bit processing will be possible together. The reference numeral 110 is a partial output data of the upper bit group, 111 is a partial output data of the lower bit group, and from these two, a post-processing circuit 112 produces an output signal 105 (filter-output data) of the same bit length as the input signal.

In the case of such an FIR filter, in realizing steep filter characteristics which are desirable to the system, it is necessary to provide a large scale circuit of high order (for example, refer to "Fundamentals of Digital Signal Processing" Chap.4-4.2 edited by Shigeo Tsujii, 1988, Corona publishing co.), but in fact, it is generally difficult to provide a sufficient scaled filter because of the limitation in chip area of LSI and gate number of FPGA. Particularly when a high-bit high precision signal processing is needed, the necessary gate number and implementing area presumably increase according to square bit-number, hence above difficulty increases.

In addition, in digital signal processing, a subject signal is changed (sampled) to a digital signal before processing, but in doing so, it is necessary to sample it at the higher frequency of 10 times or more of the upper limit of its frequency range, and the succeeding digital signal processing circuits must also be operated at the same throughput. That is to say, a subject signal with a frequency range of the upper limit of 10MHz will need to be sampled at a frequency of 100MHz or above, and will need to be provided with a digital processing circuit which operates at a frequency of 100MHz or above, and also, to process a signal up to 100MHz, digital signal processing circuits operating at a frequency of 1GHz or above is necessary. Thus a digital signal processing circuit requires a high operating frequency.

However, at present, except certain specially configured CPUs, the operating frequency of a digital circuit feasible by an LSI technique with a generally available CMOS process is approximately less than 2GHz, and in the case of configuring a large scale digital filter, the operating frequency decreases even more, and in effect, it is impossible to develop an LSI operating at 1GHz or above at a low cost.

Thus the purpose of the present invention is to manufacture a high-order and high-precision FIR filter, i.e. a large-scale digital filter capable of high-speed operation of 2 GHz or above at a low cost.

Disclosure Of the Invention

The present invention which has advantageously solved the above-mentioned problem is characterized by its configuration of a high-speed, high-order and high-precision FIR filter, i.e. a large-scale digital filter by combining a variety of FIR filter element circuits capable of high-speed operation to operate synchronously, and this variety of element circuits may be substituted by a single kind of element circuit.

That is to say, the FIR filter of the present invention comprises a plurality of input delay circuits which are mutually connected in cascade and each of which delays the input data and outputs it, and a plurality of multiplier circuits each of which multiplies respective input data of said plurality of input delay circuit and the output data of the input delay circuit of the final stage by respective coefficients to make partial output data, and FIR filter which sums up partial output data of said plurality of multipliers to make filter output data is characterized in that said FIR filter comprises a plurality of element circuits which have one or more input delay circuits each of which is configured by dividing said plurality of input delay circuits mutually connected in cascade in the direction of the cascade, and one or more multiplier circuits connected to said one or more input delay circuits, and which obtain partial sum data from partial output data of said one or more multiplier circuits, and among said plurality of element circuits, the initial stage element circuit outputs said partial sum data directly, and each of the succeeding element circuits from the second stage outputs the partial sum data obtained by adding delayed said partial sum data obtained inside that element circuit to partial sum data output by the element circuit of the prior stage, and the element circuit of the final stage outputs the partial sum data as the filter output data.

In addition, the element circuit of the present invention is characterized by having one or more of said input delay circuits mutually connected in cascade, and one or more of said multiplier which multiply to each one of the input data from one or more of said input delay circuits by a coefficient to make partial output data, and a partial output adder which adds the partial output data from one or more of said multiplier mutually to make partial sum data, or in addition by having a partial sum delay circuit which delays partial sum data of said partial output adder, and a partial sum adder which adds the partial sum data delayed by said partial sum delay circuit and partial sum data of said initial stage element circuit or said intermediate stage element circuit of the prior stage to make partial sum data, or, by having a partial sum delay circuit which delays partial sum data from said partial output adder, and a partial sum adder which adds partial sum data delayed by said partial sum delay circuit and the partial sum data from said intermediate stage element circuit of the prior stage to make the filter output data.

According to the FIR filter of the present invention, it has one or more input delay circuit configured by dividing(slicing) a number of input delay circuits mutually connected in cascade of the FIR filter in the middle of the taps into a plurality, and a plurality of element circuits which has one or more multiplier connected to said one or more input delay circuits and obtains the partial sum data from the partial output data of said multiplier, and in those element circuits, the initial stage element circuits output said partial sum data without modification, and from the second stage element circuits onward, partial sum data obtained by adding delayed said partial sum data obtained in the element circuits to the partial sum data output by the prior element circuit, is output, especially the element circuit of the last stage amongst the stages succeeding the second stage, modifies the partial sum data to make a filter output data by synchronizing and adding the partial sum data from said plurality of element circuits together, hence it is possible to manufacture a tap-slice type FIR filter having an arbitrary order and accuracy(number of bits), and capable of high-speed operation of 2 GHz or above.

However, the FIR filter of the present invention may be comprised of one initial stage element circuit comprised of one or more of said input delay circuit mutually connected in cascade into which filter input data is input, and one or more of said multiplier circuits each of which multiplies one or more input data of the input delay circuit by respective coefficients to make partial output data, and a partial output adder which adds said one or more partial output data mutually to make partial sum data of said one or more multiplier circuits, and one or more intermediate stage element circuits comprised of a plurality of said input delay circuits mutually connected in cascade, into which said initial stage element circuit or the output data from the final stage input delay circuit of said intermediate stage element circuit of the prior stage is input, and one or more of said multiplier circuits which multiply the input data from one or more of said input delay circuits by respective coefficients to make partial output data, and a partial output adder which adds the partial output data from one or more of said multiplier circuits mutually to make partial sum data, and a partial sum delay circuit which delays partial output data of said partial output adder, and a partial sum delay circuit which delays the partial sum data from said partial output adder, and a partial sum adder which adds partial sum data delayed by said partial sum delay circuit and partial sum data of said initial stage element circuit or said intermediate stage element circuit of the prior stage to make partial sum data, and a final stage element circuit comprised of one or more of said input delay circuits mutually connected in cascade , into which the output data from the final stage input delay circuit of said intermediate stage element circuit of the prior stage is input, and a plurality of said multiplier circuits which the input data from one or more of said input delay circuits and the output data from the last stage input delay circuit by respective coefficients to make partial output data, and a partial output adder which adds partial output data of said plurality of multiplier circuits mutually to make partial sum data, and a partial sum delay circuit which delays partial sum data of said partial output adder, and a partial sum adder which adds partial sum data delayed by said partial sum delay circuit and partial sum data of said intermediate stage element circuit of the prior stage to make filter output data, and in this way, in the partial sum delay circuit incorporated in the intermediate stage element circuit and the final stage element circuit, partial sum output data of the element stages from initial stage element circuit to final stage element circuit and inner partial sum data of the element circuit can be synchronized with and added, thus it is possible to realize a tap-slice type FIR filter having an arbitrary order and accuracy (bit number) and capable of high-speed operation of 2 GHz or above, and moreover, owing to the mass-production effect of the element circuits being assembled in 3 parts; the initial stage element circuit, the intermediate stage element circuit, and the final stage element circuit, the cost of the high-end digital filter is easily reducible.

In addition, the FIR filter of the present invention may be comprised of a plurality of element circuit sets which correspond respectively to a plurality of divided input data divided from the original filter input data, each element circuit set configured by said initial stage element circuit, said intermediate stage element circuit, and said final stage element circuit, and a plurality of element circuit sets in which said coefficients of said multiplier circuits of the element circuits corresponding to the stage of each of the element circuit sets are made equal, and a filter output adder which aligns the decimal point and sums up the partial output data as a filter output data output by said final stage element circuit of said plurality of element circuit sets, and outputs the filter output data having a bit length corresponding to that of the original input data, and in this way, a bit-slice type FIR filter is also realizable by the FIR filter of the present invention, and a larger-scale digital filter may be configured.

Moreover, in the FIR filter of the present invention, said coefficient of said multiplier circuit may be made variable, and in this way, the filter characteristics can be changed arbitrarily, and a large-scale adaptive digital filter may be configured.

Meanwhile, an element circuit of the FIR filter of the present invention having one or more of said input delay circuit mutually connected in cascade, and one or more of said multiplier circuits which multiply the input data from one or more of said input delay circuits by respective coefficients to make partial output data, and a partial output adder which adds the partial output data from one or more of said multiplier circuits mutually to make partial sum data, may be used for the initial stage element circuits of said FIR filter of the present invention, and in addition an element circuit of the FIR filter of the present invention having a partial sum delay circuit which delays partial output data of said partial output adder, and a partial sum adder which adds partial sum data delayed by said partial sum delay circuit and partial sum data of said initial stage element circuit or said intermediate stage element circuit of the prior stage to make partial sum data, may be used for the intermediate stage element circuits of said FIR filter of the present invention, and in addition to the first element circuit, an element circuit of said FIR filter of the present invention having a partial sum delay circuit which delays partial sum data from said partial output adder, and a partial sum adder which adds partial sum data delayed by said partial sum delay circuit and the partial sum data from said intermediate stage element circuit of the prior stage to make filter output data may be used for the final stage element circuit of said FIR filter of the present invention.

In addition, the element circuits of the FIR filter which may be used in said intermediate stage element circuits sorts, by not using part of the components or data, may function as a substitute for at least either said initial stage element circuit or said final stage element circuit, and in this way, the number of the element circuits may be decreased to increase the mass-production effect and the cost of the high-end digital filter can be reduced even more.

Furthermore, in the element circuits of said FIR filter, said coefficient of said multiplier circuit may be made variable, and in this way, the filter characteristics can be changed arbitrarily, and a large-scale adaptive digital filter may be configured easily.

(Brief Description Of the Drawings)

Fig.1 is a schematic diagram illustrating a bit-slice type FIR filter as an embodiment of the FIR filter of the present invention.

Fig.2 is a schematic diagram illustrating a tap-slice configuration used in each of the element circuit sets of the above embodiment of the FIR filter.

Fig.3 is a schematic diagram illustrating an initial stage element circuit as an embodiment of the element circuit for the FIR filter of the present invention, which may be used in the above embodiment of the FIR filter.

Fig.4 is a schematic diagram illustrating an intermediate stage element circuit as an embodiment of the element circuit for the FIR filter of the present invention, which may be used in the above embodiment of the FIR filter.

Fig.5 is a schematic diagram illustrating a final stage element circuit as an embodiment of the element circuit for the FIR filter of the present invention, which may be used in the above embodiment of the FIR filter.

Fig.6 is a schematic diagram illustrating a post-processing circuit as an embodiment of the element circuit for the FIR filter of the present invention, which may be used in the above embodiment of the FIR filter.

Fig.7 is a schematic diagram illustrating the setting method of the delay setting value in the partial sum delay circuit according to the present invention.

Fig.8 is a diagram illustrating the principle of the FIR filter.

Fig.9 is a schematic diagram illustrating an adaptive digital filter type FIR filter.

Fig.10 is a schematic diagram illustrating the bit-slice configuration FIR filter.

[Best Mode for Carrying Out the Invention]

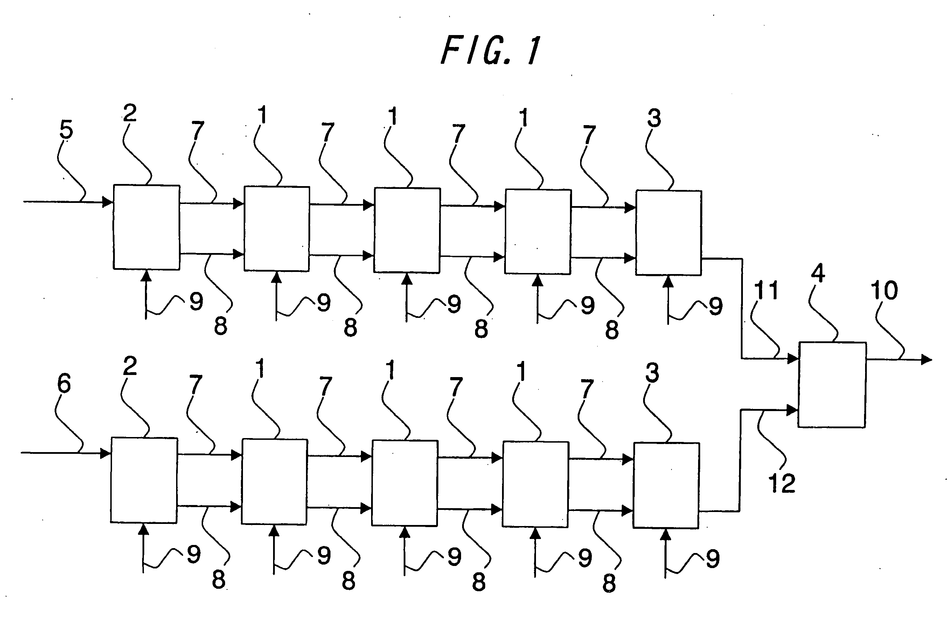

Fig.1 is a schematic diagram illustrating the overview of the bit-slice type FIR filter as an embodiment of the FIR filter of the present invention. The reference numerals 1 to 4 in the diagram indicate the element circuits which configure one FIR filter, where 1 indicates the intermediate stage element circuit, 2 indicates the initial stage element circuit, 3 indicates the final stage element circuit, and 4 indicates the post-processing circuit as a filter output adder of bit-slice configuration. On the other hand, the reference numerals 5 to 12 indicate the signals which are exchanged between the element circuits, where 5 indicates the upper bit group of the input data as a filter input data, 6 indicates the lower bit group of the input signal, 7 indicates the input data which is delayed each time as it passes on through element circuits 1 to 3, 8 indicates the partial sum data which is passed through element circuits 1 to 3, 9 indicates the multiplier coefficient/partial sum delay setting signal which sets the coefficient of the multiplier in each of element circuits 1 to 3 and the delay degree of the partial sum delay circuit, 10 indicates the output signal as an filter output data, 11 indicates the partial output data of the upper bit group, and 12 indicates the partial output data of the lower bit group.

According to the present invention, an FIR filter is configured by 4 sorts of element circuits including the post-processing circuit 4. The input signal (filter input data) is generally input as a multiple-bit digital signal, but in this embodiment, the input signal is divided into two bit groups of the upper and lower, and bit-slice configuration is employed so as to enable bit- slice processing on both groups separately. For example, if the input signal is 24 bits wide, the upper 12 bits are assigned to the upper bit group 5, and the lower 12 bits are assigned to the lower bit group 6. The FIR filter of the present invention is configured by 3 sorts of element circuits 1 to 3 with the exclusion of the post-processing circuit 4, and the reason these 3 sorts of circuits are necessary is because the input and output data of each of the element circuits differ slightly. As illustrated, the 3 sorts of element circuits 1 to 3 are connected in cascade and arranged in sets, and the number of the sets is equal to the number of bit-slices; in this embodiment 2 sets, in the diagram disposed one above the other, to obtain the final output data 10 by processing each of the output signals 11 and 12 from these two element circuit sets with the post- processing circuit 4 as a filter output adder. In addition, the inner multiplier coefficient and the delay degree of the partial sum delay circuit of the element circuits 1 to 3 is designed to be variable, and are made externally settable by the setting signal 9. Meanwhile, the multiplier coefficient of the multiplier in the corresponding tap position of the multipliers of the 2 above mentioned element circuit sets which respectively processes the 2 bit groups must be made aligned (equal) to each other.

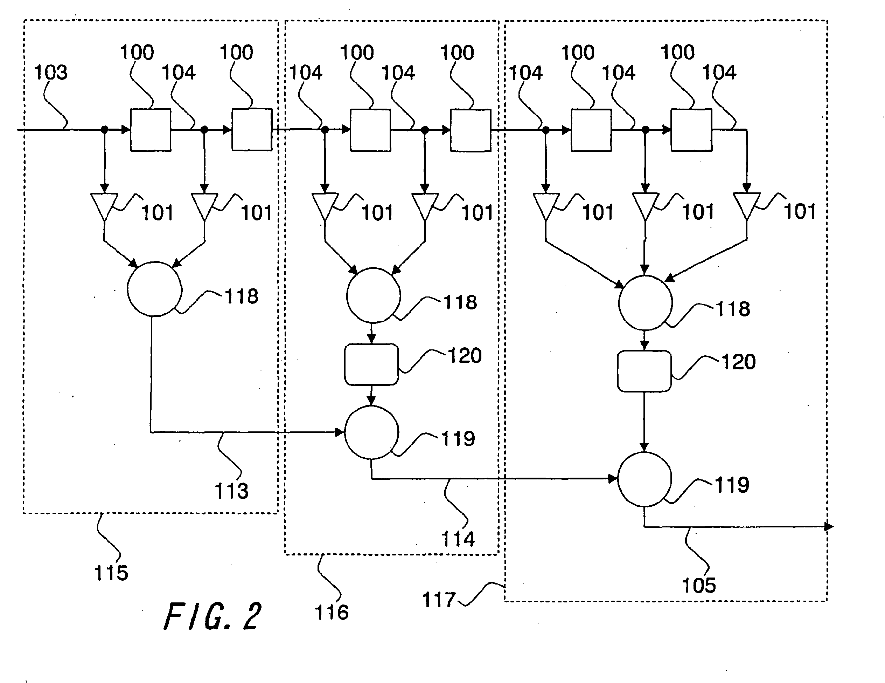

Fig.2 is a concrete configuration example of how an FIR filter may be divided in a tap-column direction (the cascade connection direction of the delay circuit 100), used in each of the element circuit sets in the bit-slice configuration of the embodiment shown in Fig.1. The example as shown in Fig.2 divides the FIR filter into a single-staged initial stage element circuit 115 corresponding to the above mentioned initial stage element circuit 2, an intermediate stage element circuit 116 shown here as single-staged corresponding to the above mentioned intermediate stage element circuit 1, and a single-staged final stage element circuit 117 corresponding to the above mentioned final stage element circuit 3, and differs in number of intermediate stage element circuits as compared to Fig.1, but the number of intermediate stage element circuits may be properly changed. Here, initial stage element circuit 115 and intermediate stage element circuit 116 process 2 taps of data, and final stage element circuit 117 processes 3 taps of data, where each of the circuits adds the partial output data obtained by multiplying the input data from the taps at the multiplier 101 as a multiplier circuit, at the partial output adder 118 for the number of taps in the element circuits to calculate partial sum output data, then initial stage element circuit 115 outputs the calculated value itself as the partial sum data 113 of the element circuits.

The intermediate stage element circuit 116 calculates the inner partial sum data of the element circuits at the partial output adder 118, then delays properly that partial sum data at the partial sum delay circuit 120, and calculates the sum of the delayed partial sum data and partial sum data 113 (in the case of having a plurality of intermediate stage element circuits 116, after the second intermediate stage element circuit 116, partial sum data 114 from the intermediate stage element circuit 116 of the prior stage is employed) from the initial stage element circuit 115 of the prior stage at the partial sum adder 119, and outputs the value of the calculation result as the partial sum data 114 of the intermediate stage element circuit 116.

The final stage element circuit 117 is the same as the intermediate stage element circuit 116, and after calculating the inner partial sum data of the element circuits at the partial sum adder 118, it properly delays the partial sum data at the partial sum delay circuit 120 and calculates the sum of the delayed sum data and the partial sum data 114 from the intermediate stage element circuit 116 of the prior stage at the partial sum adder 119, and outputs the value of the calculation result as the output signal 105.

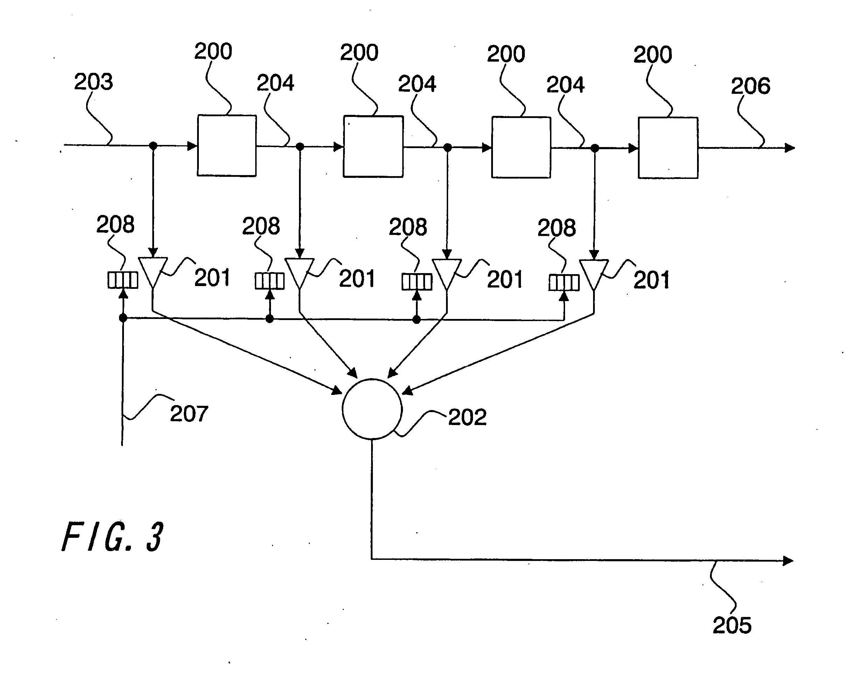

Next, we explain the element circuits which an adaptive digital filter may configure, as shown in Fig.9, and which may be used for the FIR filter of the above-mentioned embodiment. Fig.3 shows an initial stage element circuit as an embodiment of the element circuit for the FIR filter of the present invention corresponding to said initial stage element circuit 2 and initial stage element circuit 115, and in this embodiment, 4 taps of delay circuits and multipliers are implemented on the element circuit. The reference numeral 200 indicates the delay circuit, 201 is the multiplier, and 202 indicates an adder as a partial output adder. In addition, the reference numeral 203 indicates the input signals for the element circuits, 204 is the input data of the next stage which is the output data of the delay circuit 200, 205 is the partial sum output data of said element circuit, and 206 is the delayed output data being passed on to the element circuits of the next stage.

Furthermore, the reference numeral 207 indicates the multiplier coefficient/partial sum delay setting signal, and 208 is the multiplier coefficient memory of the multiplier 201.

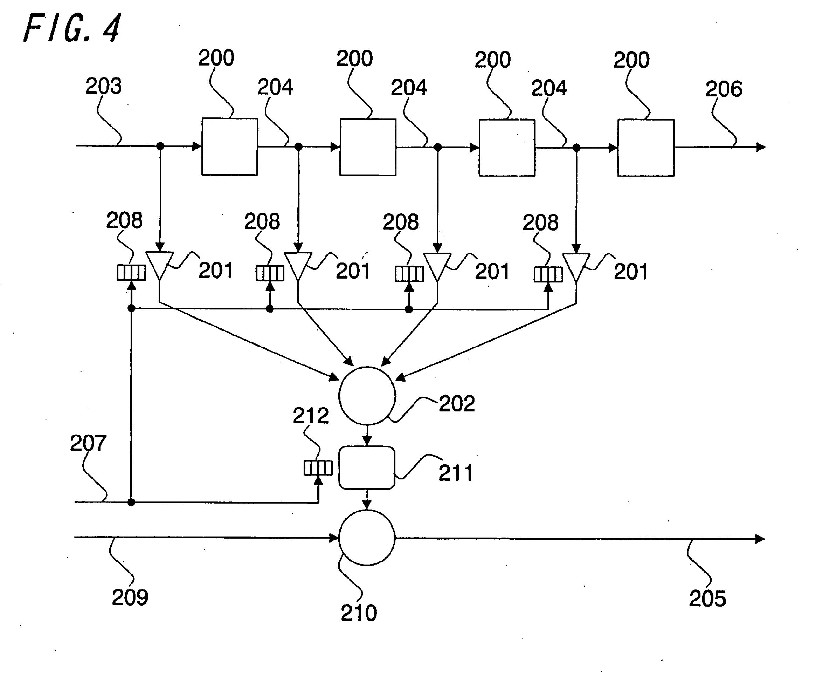

Fig.4 shows an intermediate stage element circuit as an embodiment of the element circuit for the FIR filter of the present invention corresponding to said intermediate stage element circuit 1 and intermediate stage element circuit 116, and in this embodiment, 4 taps of delay circuits and multipliers are implemented as an element circuit. From the reference numeral 200 through 208 is the same as Fig.3. the reference numeral 209 indicates the partial sum input data which is the partial sum output data 205 of the prior stage element circuits. The inner partial sum data of said element circuit calculated by adder 202 is delayed properly at partial sum delay circuit 211, and is added to partial sum input data 209 at partial sum adder 210, and is output as a partial sum output data 205 of said element circuits. The delay time (the degree of delay) of the partial sum delay circuit 211 may be changed by the setting value of partial sum delay setting memory 212. In addition, the value of the partial sum delay setting memory 212 is settable by the multiplier coefficient/partial sum delay setting signal 207.

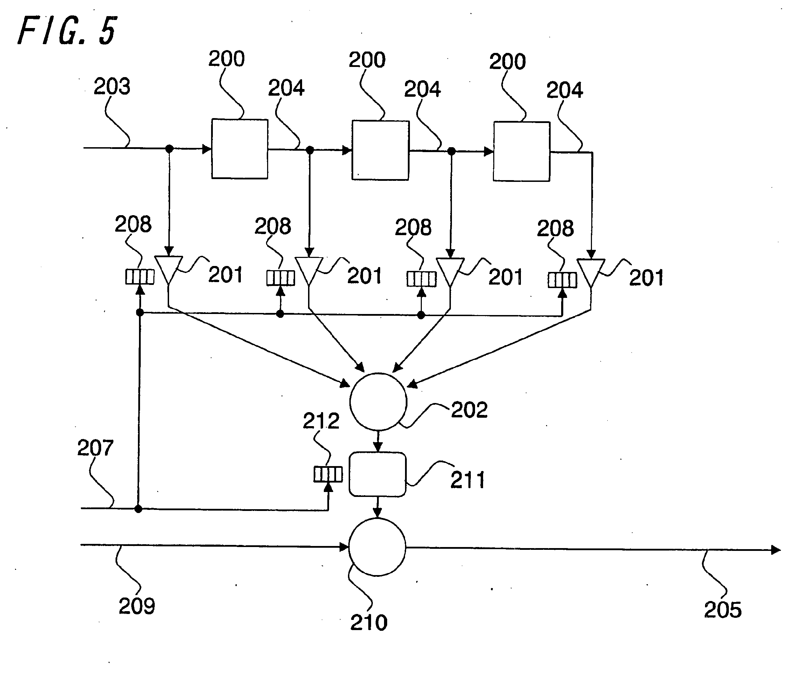

Fig.5 shows a final stage element circuit as an embodiment of the element circuit for the FIR filter of the present invention corresponding to said final stage element circuit 3 and final stage element circuit 117, and in this embodiment, 4 taps of delay circuits and multipliers are implemented as an element circuit. The configuration in this diagram is mostly the same as the intermediate stage element circuit of Fig.4, and the only difference is that here, the number of the delay circuit 200 is smaller by one, and no delay output data 206 is passed on to the next stage.

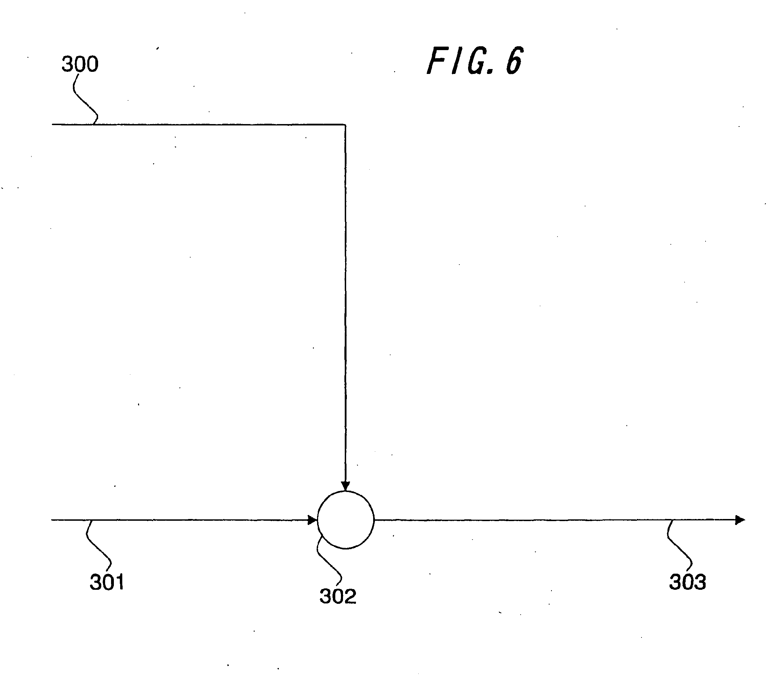

Fig.6 shows a post-processing circuit as an embodiment of the element circuit for the FIR filter of the present invention corresponding to said post-processing circuit 4, and this embodiment shows a case in which bit-slice processing is carried out, by dividing the input data into the upper and lower bit groups. The reference numeral 300 is the partial output data for the upper bit group and 301 is the partial output data for the lower bit group. These partial output data, 300 and 301, the decimal point of which are aligned to each other, are added by the partial data adder 302, to result in a filter output data 303 which is the final output signal of the FIR filter.

According to the initial stage element circuit, intermediate stage element circuit, and final stage element circuit of these embodiments, it is possible to synchronize and to add the partial sum output data of the element circuits and the inner partial sum data of the element circuits by the partial sum delay circuit 211 implemented in the intermediate stage element circuit and the final stage element circuit, thus a tap-slice type FIR filter having an arbitrary order and accuracy(number of bits), and capable of high-speed operation of 2 GHz or above is realizable, and moreover, owing to the mass-production effect of the element circuits being assembled in 3 parts; the initial stage element circuit, the intermediate stage element circuit, and the final stage element circuit, the cost of the high-end digital filter is easily reducible, and furthermore, the value of the multiplier coefficient , which is stored by the multiplier coefficient memory 208 of the multiplier 201, is settable/valuable by multiplier coefficient/partial sum delay setting signal 207, therefore, it is possible to change the filter characteristics arbitrarily and configure a large scale adaptive digital filter. Also, according to the initial stage element circuit, intermediate stage element circuit, final stage element circuit, and the post-processing circuit of this embodiment, a bit-slice type FIR filter capable of having the same effect, as mentioned-above, for data with a wider bit width is realizable.

In the above explanations, the FIR filter was configured by 4 sorts of element circuits, but according to the present invention, it is possible to configure the FIR filter by less sorts of element circuits. First, the final stage element circuit of Fig.5 is clearly substitutable by the intermediate stage element circuit of Fig.4. In other words, by not connecting or not using the element circuit delay output data 206 in Fig.4, it is possible to attain the same function as the final stage element circuit in Fig.5. Secondly, the initial stage element circuit in Fig.3 is also substitutable by the intermediate stage element circuit of Fig.4, and in fixing the value of the element circuit partial sum input data 209 in Fig.4 to 0, and setting the delay of partial sum delay circuit 211 to 0, the same function as the initial stage element circuit in Fig.3 is realized.

Moreover, the post-processing circuit in Fig.6 is also substitutable by the intermediate stage element circuit of Fig.4. That is to say, the value on the most left amongst the multiplier coefficients of the multiplier 201 is set to 1, and the rest of the coefficients are set to 0, and also the delay of partial sum delay circuit 211 is set to 0. In this situation, by inputting the upper-bit group partial data 300 as the input data 203, aligning the decimal point and inputting the lower-bit group partial data 301 as an element circuit partial sum input data 209, it is possible to obtain the same output data as the complete output data 303 as the element circuit partial sum output data 205. In this case, likewise the final stage element circuits in Fig.5, the element circuit delay output data 206 is not used.

In this way, according to the present invention, it is possible to configure a large-scale FIR filter having many taps, and an arbitrary characteristic for a wide range of width in bits of the data by using only intermediate stage element circuit.

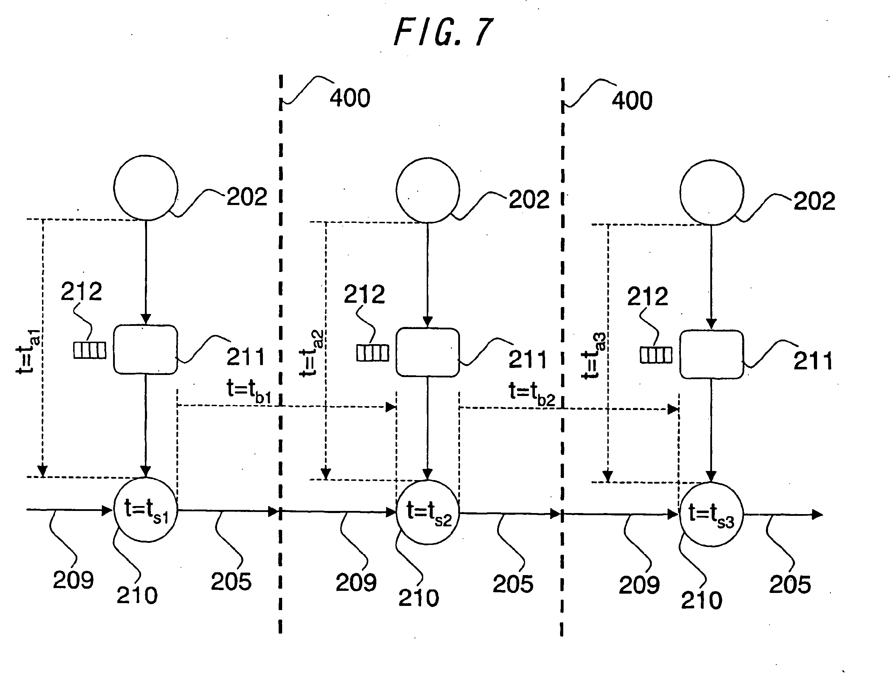

Fig.7 shows an example of the calculation method of the delay setting value of the partial sum delay circuit, and this example shows a case in which 3 intermediate stage element circuits are connected in cascade. The components corresponding to the components shown in Fig.3 to Fig.5 are indicated by the same numerals. Firstly, the delay setting value of the partial sum delay setting memory 212 of the partial sum delay circuit 211 is set to 0 at the first-stage element circuit on the left hand side of the diagram, and the time needed for the output of adder 202 to pass through partial sum delay circuit 211 and reach the input of partial sum adder 210 is represented, by $t=t_{a1}$. In addition, the time needed for the calculation inside partial sum adder 210 is represented by $t=t_{s1}$, the time needed for the output of partial sum adder 210 to pass through the interface 400 between the element circuits and reach the input of partial sum adder 210 of the next stage element circuit is represented by $t-t_{b1}$. Also, as for the element circuits in the middle of the diagram and the element circuits on the right, $t_{a2}$, $t_{s2}$, $t_{b2}$, $t_{a3}$, $t_{s3}$ are defined likewise. Here, the times except for the delay setting values, $t_{a2}$ and $t_{a3}$ may be calculated from circuit disposition, but for purposes of accuracy, it is desired to be obtained by experiment in actual circuits.

Thus, the delay setting value of the partial sum delay circuit 211 in the second stage should be set so as to satisfy the following equation (1).

$$t_{a1} + t_{s1} + t_{b1} = t_{a2} \dots (1)$$

In addition, the delay setting value of the partial sum delay circuit 211 in the third stage is likewise, and should be set so as to satisfy the following equation (2).

$$t_{a2} + t_{s2} + t_{b2} = t_{a3} \dots (2)$$

Thus far, the explanations were according to the illustrated examples, but the present invention is not limited to said example of the bit-slice type, and for example, it may configure a tap-slice type FIR filter as shown in Fig.8 and a tap-slice type adaptive digital filter as shown in Fig.9.

Also, said element circuits for the FIR filter of the present invention may be realized as a LSI chip, and configure a large-scale FIR filter by connecting inside a multi-chip module or a SIP (System In Package), or be realized as one chip one package, and realize a large-scale FIR filter on the printed board.

Moreover, these element circuits may be realized as a hard macro or a soft macro for a LSI, be connected in an LSI and realize a large-scale FIR filter as a part of the SOC (System On a Chip), or providing FPGAs and CPLDs with these element circuits built in, and connecting the element circuits using the variable connecting function of the FPGA and CPLD, or realize a large-scale FIR filter by using the built-in module of FPGA and CPLD together.

Furthermore, these element circuits may be realized as a hybrid IC, a circuit module, a daughter board, or a printed board having a card connecter and the like, and realizing a large-scale FIR filter which connects these circuits likewise, and in the same way, realizing a large-scale FIR filter by configuring these element circuits inside a vessel made of metal or plastic, and connecting the circuits with connecters and cables for intersystem connections.

Industrial application potency

The present invention is applicable to the implementation of all sorts of filters from high-end to low-end, and enables to facilitate the realization of an FIR filter at low cost.

**Claims**

1. An FIR filter comprising a plurality of input delay circuits (100) which are mutually connected in cascade and each of which delays the input data and outputs it, and a plurality of multiplier circuits (101) each of which multiplies respective input data of said plurality of input delay circuit and the output data of the input delay circuit of the final stage by respective coefficients to make partial output data, and which sums up partial output data of said plurality of multiplier circuits to make filter output data, **characterized in that**
said FIR filter comprises a plurality of element circuits which have one or more input delay circuits each of which is configured by dividing said plurality of input delay circuits mutually connected in cascade in the direction of the cascade, and one or more multiplier circuits (101) connected to said one or more input delay circuits, and which obtain partial sum data from partial output data of said one or more multiplier circuits,
and among said plurality of element circuits, the initial stage element circuit outputs said partial sum data (113, 114) directly, and each of the succeeding element circuits from the second stage outputs the partial sum data obtained by adding (119) delayed said partial sum data obtained inside that element circuit to partial sum data output by the element circuit of the prior stage, and the element circuit of the final stage outputs the partial sum data as the filter output data (105).

2. A FIR filter according to claim 1, **characterized in that** it comprises one initial stage element circuit which has one or more of said input delay circuits mutually connected in cascade into which filter input data is input (103), and said one or more of said multiplier circuits each of which multiplies each of the input data of said one or more input delay circuits by respective coefficient to make partial output data, and a partial output adder (118) which adds partial output data of said one or more multiplier circuits mutually to make partial sum data,
one or more intermediate stage element circuits each of which has one or more of said input delay circuits mutually connected in cascade into which the output data of said initial stage element circuit or the output data from the final input delay circuit of said intermediate stage element circuit of the prior stage is input, and said one or more of said multiplier circuits each of which multiplies each one of the input data from said one or more of said input delay circuits by respective coefficient to make partial output data, and a partial output adder (119) which adds the partial output data from said one or more multiplier circuits mutually to make partial sum data, and a partial sum delay circuit which delays the partial sum data of said partial output adder, and a partial sum adder which adds partial sum data delayed by said partial sum delay circuit (120) and partial sum data of said initial stage element circuit or said intermediate stage element circuit of the prior stage to make partial sum data and
a final stage element circuit which has one or more of said plurality of input delay circuits mutually connected in cascade into which the output data from the final input delay circuit of said intermediate stage element circuit of the prior stage is input, and said plurality of multiplier circuits (161) each of which multiplies each one of the input data from one or more of said plurality of input delay circuits and the output data from the final stage of the input delay circuit by respective coefficient to make partial output data, and a partial output adder which adds the partial output data from said plurality of multiplier circuits mutually to make partial sum data, a partial sum delay circuit which delays the partial sum data of said partial output adder, and a partial sum adder which adds partial sum data delayed by said partial sum delay circuit and partial sum data of said intermediate stage element circuit to make the filter output data.

3. A FIR filter according to claim 2 **characterized in that** it
comprises a plurality of element circuit sets each of which corresponds to the respective one of a plurality of divided input data divided from the original filter input data, each element circuit set is composed of said initial stage element circuit, said intermediate stage element circuit, and said final stage element circuit, and among the plurality of element circuit sets, said coefficients of said multiplier circuits (101) of all the element circuits corresponding to the same stage are made equal, and it comprises a filter output adder which aligns the decimal points and sums up the partial output data as a filter output data output by said final stage element circuit of said plurality of element circuit sets, and outputs the filter output data having a bit length corresponding to that of the original input data.

4. A FIR filter according to claim 2 or 3 **characterized in that** said coefficients of said multiplier circuits (101) are variable.

5. An element circuit for an FIR filter according to any one of the claims 1 to 4 **characterized in that** it has one or more of said input delay circuits (100) mutually connected in cascade,
one or more of said multiplier circuits (101) each of which multiplies each one of the input data from said one or more input delay circuits by respective coefficient to make partial output data and
a partial output adder (118) which adds the partial output data from said one or more multiplier circuits mutually to make partial sum data.

6. An element circuit for an FIR filter according to any one of the claims 1 to 4 **characterized in that** it has one or more of said input delay circuits mutually connected in cascade,
one or more of said multiplier circuits (101) each of which multiplies each one of the input data from said one or more input delay circuits by respective coefficient to make partial output data,
a partial output adder (118) which adds the partial output data from said one or more multiplier circuits mutually to make partial sum data,
a partial sum delay circuit (120) which delays the partial sum data of said partial output adder and
a partial sum adder which adds partial sum data delayed by said partial sum delay circuit and partial sum data of said initial stage element circuit or said intermediate stage element circuit of the prior stage to make partial sum data.

7. An element circuit for an FIR filter according to any one of the claims 1 to 4 **characterized in that** it has one or more of said input delay circuits (100) mutually connected in cascade,
one or more of said multiplier circuits (101) each of which multiplies the input data from said one or more input delay circuits the output data from the input delay circuit of the final stage by respective coefficient to make partial output data
a partial output adder (118) which adds the partial output data from one or more of said multiplier circuits mutually to make partial sum data,
a partial sum delay circuit which delays the partial output data of said partial output adder and
a partial sum adder (119) which adds the partial sum data delayed by said partial sum delay circuit and the partial sum data of said intermediate stage element circuit of the prior stage to make filter output data.

8. An element circuit for an FIR filter according to claim 6
**characterized in that** said element circuit for an FIR filter is substituted by at least one of said initial stage element circuit (115) and said final stage element circuit (117).

9. An element circuit for the FIR filter according to any one of the claims 5 to 8 **characterized in that** said coefficients of said multiplier (101) circuits are variable.

**Patentansprüche**

1. FIR-Filter, welcher umfasst: mehrere Eingabeverzögerungsschaltungen (100), die wechselseitig in Kaskade verbunden sind und wovon jede die Eingabedaten verzögert und ausgibt, und mehrere Multiplikationsschaltungen (101), wovon jede jeweilige Eingabedaten der mehreren Eingabeverzögerungsschaltungen und die Ausgabedaten der Eingabeverzögerungsschaltung der Endstufe zum Erzeugen von Teilausgabedaten mit entsprechenden Koeffizienten multipliziert, und die Teilausgabedaten der mehreren Multiplikationsschaltungen zum Erzeugen von Filterausgabedaten addiert, **dadurch gekennzeichnet, dass**
der FIR-Filter umfasst: mehrere Elementschaltungen, die eine oder mehrere Eingabeverzögerungsschaltungen aufweisen, wovon jede durch Teilen der mehreren, wechselseitig in Kaskade verbundenen Eingabeverzögerungsschaltungen in Richtung der Kaskade konfiguriert ist, und eine oder mehrere Multiplikationsschaltungen (101), die mit der einen oder den mehreren Eingabeverzögerungsschaltungen verbunden sind und die Teilsummendaten aus Teilausgabedaten der einen oder der mehreren Multiplikationsschaltungen erhalten;
und dass von den mehreren Elementschaltungen die Anfangsstufen-Elementschaltung die Teilsummendaten (113, 114) direkt ausgibt und jede der folgenden Elementschaltungen der zweiten Stufe die erhaltenen Teilsummendaten durch verzögertes Addieren (119) der in der Elementschaltung erhaltenen Teilsummendaten zu den von der Elementschaltung der vorherigen Stufe ausgegebenen Teilsummendaten ausgibt und die Elementschaltung der Endstufe die Teilsummendaten (105) als Filterausgabedaten ausgibt.

2. FIR-Filter nach Anspruch 1, **dadurch gekennzeichnet, dass** er umfasst:

eine Anfangsstufen-Elementschaltung, die aufweist: eine oder mehrere der wechselseitig in Kaskade verbundenen Eingabeverzögerungsschaltungen, in die Filter-Eingabedaten eingegeben (103) werden, und die eine oder die mehreren der Multiplikationsschaltungen, wovon jede alle Eingabedaten der einen oder mehreren Eingabeverzögerungsschaltungen mit jeweiligen Koeffizienten multipliziert, um Teilausgabedaten zu erzeugen, und einen Teilausgabeaddierer (118), der Teilausgabedaten der einen oder der mehreren Multiplikationsschaltungen wechselseitig addiert, um Teilsummendaten zu erzeugen;
eine oder mehrere Zwischenstufen-Elementschaltungen, von denen jede aufweist: eine oder mehrere der wechselseitig in Kaskade verbundenen Eingabeverzögerungsschaltungen, in die die Ausgabedaten der Anfangsstufen-Elementschaltung oder die Ausgabedaten der letzten Eingabverzögerungsschaltung der Zwischenstufen-Elementschaltung der vorherigen Stufe eingegeben werden, und die eine oder die mehreren der Multiplikationsschaltungen, wovon jede alle Eingabedaten von der einen oder den mehreren Eingabeverzögerungsschaltungen mit dem jeweiligen Koeffizienten multipliziert, um Teilausgabedaten zu erzeugen, und einen Teilausgabeaddierer (119), der die Teilausgabedaten der einen oder der mehreren Multiplikationsschaltungen zum Erzeugen von Teilsummendaten wechselseitig addiert, und eine Teilsummenverzögerungsschaltung, die die Teilsummendaten des Teilausgabeaddierers verzögert, und einen Teilsummenaddierer, der durch die Teilsummenverzögerungsschaltung (120) verzögerten Teilsummendaten und Teilsummendaten der Anfangsstufen-Elementschaltung oder der Zwischenstufen-Elementschaltung der vorherigen Stufe addiert, um Teilsummendaten zu erzeugen, und
eine Endstufen-Elementschaltung, die aufweist: eine oder mehrere der wechselseitig in Kaskade verbundenen Eingabeverzögerungsschaltungen, in die die Ausgabedaten der Endstufen-Verzögerungsschaltung der Zwischenstufen-Elementschaltung der vorherigen Stufe eingegeben werden, und die mehreren der Multiplikationsschaltungen (101), wovon jede alle Eingabedaten von einer oder mehreren der mehreren Eingabeverzögerungsschaltungen und die Ausgabedaten von der Endstufe der Eingabeverzögerungsschaltung mit einem jeweiligen Koeffizienten multipliziert, um Teilausgabedaten zu erzeugen, und einen Teilausgabeaddierer, der die Teilausgabedaten von den mehreren Multiplikationsschaltungen wechselseitig addiert, um Teilsummendaten zu erzeugen, eine Teilsummenverzögerungsschaltung, die die Teilsummendaten des Teilausgabeaddierers verzögert, und einen Teilsummenaddierer, der durch die Teilsummenverzögerungsschaltung verzögerte Teilsummendaten und Teilsummendaten der Zwischenstufen-Elementschaltung addiert, um die Filterausgabedaten zu erzeugen.

**3.** FIR-Filter nach Anspruch 2, **dadurch gekennzeichnet, dass** er mehrere Elementschaltungssätze, wovon jede der jeweiligen von mehreren geteilten Eingabedaten, die aus den ursprünglichen Filtereingabedaten geteilt wurden, entspricht, umfasst, jeder Elementschaltungssatz aus der Anfangsstufen-Elementschaltung, der Zwischenstufen-Elementschaltung und der Endstufenschaltung besteht und von den mehreren Elementschaltungssätzen die Koeffizienten der Multiplikationsschaltungen (101) aller Elementschaltungen, die der gleichen Stufe entsprechen, gleich gemacht werden, und er einen Filterausgabeaddierer umfasst, der die Dezimalstellen ausrichtet und die Teilausgabedaten als Filterausgabedaten, die durch die Endstufen-Elementschaltung der mehreren Elementschaltungssätze ausgegeben werden, addiert und die Filterausgabedaten mit einer Bitlänge ausgibt, die der der ursprünglichen Eingabedaten entspricht.

**4.** FIR-Filter nach Anspruch 2 oder 3, **dadurch gekennzeichnet, dass** die Koeffizienten der Multiplikationsschaltungen (101) veränderlich sind.

**5.** Elementschaltung für einen FIR-Filter nach einem der Ansprüche 1 bis 4, **dadurch gekennzeichnet, dass** sie aufweist:

eine oder mehrere der wechselseitig in Kaskade verbundenen Eingabeverzögerungsschaltungen (100);
eine oder mehrere der Multiplikationsschaltungen (101), wovon jede alle Eingabedaten von der einen oder den mehreren Eingabeverzögerungsschaltungen mit einem jeweiligen Koeffizienten multipliziert, um Teilausgabedaten zu erzeugen; und
einen Teilausgabeaddierer (118), der die Teilausgabedaten von der einen oder den mehreren Multiplikationsschaltungen wechselseitig addiert, um Teilsummendaten zu erzeugen.

**6.** Elementschaltung für einen FIR-Filter nach einem der Ansprüche 1 bis 4, **dadurch gekennzeichnet, dass** sie aufweist:

eine oder mehrere der wechselseitig in Kaskade verbundenen Eingabeverzögerungsschaltungen;
eine oder mehrere der Multiplikationsschaltungen (101), wovon jede alle Eingabedaten von der einen oder den mehreren Eingabeverzögerungsschaltungen mit einem jeweiligen Koeffizienten multipliziert, um Teilausgabedaten zu erzeugen;
einen Teilausgabeaddierer (118), der die Teilausgabedaten von der einen oder den mehreren Multiplikationsschaltungen wechselseitig addiert, um Teilsummendaten zu erzeugen;
eine Teilsummenverzögerungsschaltung (120), die die Teilsummendaten des Teilsummenausgabeaddierers verzögert, und
einen Teilsummenaddierer, der durch die Teilsummenverzögerungsschaltung verzögerte Teilsummendaten und Teilsummendaten der Anfangsstufen-Elementschaltung oder der Zwischenstufen-Elementschaltung der vorherigen Stufe addiert, um Teilsummendaten zu erzeugen.

**7.** Elementschaltung für einen FIR-Filter nach einem der Ansprüche von 1 bis 4, **dadurch gekennzeichnet, dass** sie aufweist:

eine oder mehrere der wechselseitig in Kaskade verbundenen Eingabeverzögerungsschaltungen (100);
eine oder mehrere der Multiplikationsschaltungen (101), wovon jede die Eingabedaten von der einen oder den mehreren Eingabeverzögerungschaltungen, die Ausgabedaten von der Eingabeverzögerungsschaltung der Endstufe mit einem jeweiligen Koeffizienten multipliziert, um Teilausgabedaten zu erzeugen,
einen Teilausgabeaddierer (118), der die Teilausgabedaten von einer oder mehreren der Multiplikationsschaltungen wechselseitig addiert, um Teilsummendaten zu erzeugen,
eine Teilsummenverzögerungsschaltung, die die Teilausgabedaten des Teilausgabeaddierers verzögert, und
einen Teilsummenaddierer (119), der die durch die Teilsummenverzögerungsschaltung verzögerten Teilsummendaten und die Teilsummendaten der Zwischenstufen-Elementschaltung der vorherigen Stufe addiert, um Filterausgabedaten zu erzeugen.

**8.** Elementschaltung für einen FIR-Filter nach Anspruch 6, **dadurch gekennzeichnet, dass** die Elementschaltung für einen FIR-Filter durch mindestens eine von Anfangsstufen-Elementschaltung (115) und Endstufen-Elementschaltung (117) ersetzt ist.

**9.** Elementschaltung für den FIR-Filter nach einem der Ansprüche 5 bis 8, **dadurch gekennzeichnet, dass** die Koeffizienten der Multiplikationsschaltungen (101) veränderlich sind.

**Revendications**

**1.** Filtre à réponse impulsionelle finie (FIR) comprenant une pluralité de circuits de temporisation d'entrée (160) qui sont connectés les uns aux autres en cascade et dont chacun temporise les données d'entrée et les émet en sortie, et une pluralité de circuits multiplicateurs (101) dont chacun multiplie des données d'entrée correspondantes de ladite pluralité de circuits de temporisation d'entrée et des données de sortie du circuit de temporisation d'entrée de l'étage final par des coefficients respectifs pour produire des données de sortie partielle, et qui additionne les données de sortie partielle de ladite pluralité de circuits multiplicateurs pour produire des données de sortie de filtre, **caractérisé en ce que**

ledit filtre FIR comprend une pluralité de circuits d'éléments comprenant un ou plusieurs circuits de temporisation d'entrée dont chacun est configuré en divisant ladite pluralité de circuits de temporisation d'entrée connectés les uns aux autres en cascade dans le sens de la cascade, et un ou plusieurs circuits de multiplication (101) connectés auxdits un ou plusieurs circuits de temporisation d'entrée, et qui obtiennent des données de somme partielle à partir des données de sortie partielle desdits un ou plusieurs circuits multiplicateurs,

et parmi ladite pluralité de circuits d'éléments, le circuit d'éléments de l'étage initial émet directement en sortie lesdites données de somme partielle (113, 114), et chacun des circuits d'éléments suivants à partir du deuxième étage émet les données de somme partielle obtenues en additionnant (119) lesdites données de somme partielle temporisées obtenues à l'intérieur du circuit d'éléments aux données de somme partielle émises en sortie par le circuit d'éléments de l'étage précédent, et le circuit d'éléments de l'étage final émet les données de somme partielle en sortie comme données de sortie de filtre (105).

2. Filtre FIR selon la revendication 1, **caractérisé en ce qu'**il comprend un circuit d'éléments d'étage initial qui possède un ou plusieurs desdits circuits de temporisation d'entrée connectés les uns aux autres en cascade et dans lesquels lesdites données d'entrée de filtre sont entrées (103), et lesdits un ou plusieurs desdits circuits multiplicateurs, dont chacun multiplie chacune des données d'entrée desdits un ou plusieurs circuits de temporisation d'entrée par un coefficient correspondant pour produire des données de sortie partielle, et un additionneur de sorties partielles (118) qui additionne les données de sortie partielle desdits un ou plusieurs circuits multiplicateurs entre elles pour produire des données de somme partielle,

un ou plusieurs circuits d'éléments d'étages intermédiaires dont chacun comprend un ou plusieurs desdits circuits de temporisation d'entrée connectés les uns aux autres en cascade dans lesquels les données de sortie dudit circuit d'éléments d'étage initial ou les données de sortie dudit circuit de temporisation d'entrée final dudit circuit d'éléments d'étage intermédiaire de l'étage antérieur sont entrées, et lesdits un ou plusieurs desdits circuits multiplicateurs dont chacun multiplie chacune des données d'entrée desdits un ou plusieurs desdits circuits de temporisation d'entrée par un coefficient correspondant pour produire des données de sortie partielle, et un additionneur de sorties partielles (119) qui additionne les données de sortie partielle provenant desdits un ou plusieurs circuits multiplicateurs entre elles pour produire des données de somme partielle, et un circuit de temporisation de somme partielle qui temporise les données de somme partielle dudit additionneur de sorties partielles, et un additionneur de sommes partielles qui additionne des données de somme partielle temporisées par ledit circuit de temporisation de somme partielle (120) et des données de somme partielle dudit circuit d'éléments d'étage initial ou dudit circuit d'éléments d'étage intermédiaire de l'étage précédent pour produire des données de somme partielle et

un circuit d'éléments d'étage final qui comprend un ou plusieurs de ladite pluralité de circuits de temporisation d'entrée connectés les uns aux autres en cascade dans lesquels les données de sortie du circuit de temporisation d'entrée final dudit circuit d'éléments d'étage intermédiaire de l'étage précédent sont entrées, et ladite pluralité de circuits multiplicateurs (161) dont chacun multiplie chacune des données d'entrée d'un ou plusieurs de ladite pluralité de circuits de temporisation d'entrée et les données de sortie de l'étage final du circuit de temporisation d'entrée par un coefficient correspondant pour produire des données de sortie partielle, et un additionneur de sorties partielles qui additionne les données de sortie partielle provenant de ladite pluralité de circuits multiplicateurs entre elles pour produire des données de somme partielle, un circuit de temporisation de somme partielle qui temporise les données de somme partielle dudit additionneur de sorties partielles, et un additionneur de sommes partielles qui additionne des données de somme partielle temporisées par ledit circuit de temporisation de somme partielle et des données de somme partielle dudit circuit d'éléments d'étage intermédiaire pour produire les données de sortie de filtre.

3. Filtre FIR selon la revendication 2, **caractérisé en ce qu'**il comporte une pluralité d'ensembles de circuits d'éléments qui correspondent chacun à l'une d'une pluralité de données d'entrée divisées qui sont divisées à partir des données d'entrée de filtre d'origine, chaque ensemble de circuits d'éléments se compose dudit circuit d'éléments d'étage initial, dudit circuit d'éléments d'étage intermédiaire et dudit circuit d'éléments d'étage final, et parmi la pluralité d'ensembles de circuits d'éléments, lesdits coefficients desdits circuits multiplicateurs (101) de tous les circuits d'éléments correspondant au même étage sont égalisés, et il comprend un additionneur de sorties de filtre qui aligne les points décimaux et additionne les données de sortie partielle sous la forme d'une donnée de sortie de filtre émise en sortie par ledit circuit d'éléments d'étage final de ladite pluralité d'ensembles de circuits d'éléments, et émet en sortie les données de sortie de filtre ayant une longueur binaire correspondant à celle des données d'entrée d'origine.

4. Filtre FIR selon la revendication 2 ou 3, **caractérisé en ce que** lesdits coefficients desdits circuits multiplicateurs (101) sont variables.

5. Circuit d'éléments pour un filtre FIR selon l'une quelconque des revendications 1 à 4, **caractérisé en ce qu'**il comprend un ou plusieurs desdits circuits de temporisation d'entrée (100) connectés les uns aux autres en cascade, un ou plusieurs desdits circuits multiplicateurs (101) dont chacun multiplie chacune des données d'entrée provenant desdits un ou plusieurs circuits de temporisation d'entrée par un coefficient correspondant pour produire des données de sortie partielle et un additionneur de sorties partielles (118) qui additionne les données de sortie partielle provenant desdits un ou plusieurs circuits multiplicateurs entre elles pour produire des données de somme partielle.

6. Circuit d'éléments pour un filtre FIR selon l'une quelconque des revendications 1 à 4, **caractérisé en ce qu'**il comprend un ou plusieurs desdits circuits de temporisation d'entrée connectés les uns aux autres en cascade, un ou plusieurs desdits circuits multiplicateurs (101) dont chacun multiplie chacune des données d'entrée provenant desdits un ou plusieurs circuits de temporisation d'entrée par un coefficient correspondant pour produire des données de sortie partielle, un additionneur de sorties partielles (118) qui additionne les données de sortie partielle provenant desdits un ou plusieurs circuits multiplicateurs entre elles pour produire des données de somme partielle, un circuit de temporisation de somme partielle (120) qui temporise les données de somme partielle dudit additionneur de sorties partielles et un additionneur de sommes partielles qui additionne les données de somme partielle temporisées par ledit circuit de temporisation de somme partielle et les données de somme partielle dudit circuit d'éléments d'étage initial ou dudit circuit d'éléments d'étage intermédiaire de l'étage précédent pour produire des données de somme partielle.

7. Circuit d'éléments pour un filtre FIR selon l'une quelconque des revendications 1 à 4, **caractérisé en ce qu'**il comporte un ou plusieurs desdits circuits de temporisation d'entrée (100) connectés les uns aux autres en cascade, un ou plusieurs desdits circuits multiplicateurs (101), dont chacun multiplie les données d'entrée provenant desdits un ou plusieurs circuits de temporisation d'entrée [et] les données de sortie du circuit de temporisation d'entrée de l'étage final par un coefficient correspondant pour produire des données de sortie partielle, un additionneur de sorties partielles (118) qui additionne les données de sortie partielle provenant d'un ou plusieurs desdits circuits multiplicateurs entre elles pour produire des données de somme partielle, un circuit de temporisation de somme partielle qui temporise les données de sortie partielle dudit additionneur de sorties partielles, et un additionneur de sommes partielles (119) qui additionne les données de somme partielle temporisées par ledit circuit de temporisation de somme partielle et les données de somme partielle dudit circuit d'éléments d'étage intermédiaire de l'étage précédent pour produire des données de sortie de filtre.

8. Circuit d'éléments pour un filtre FIR selon la revendication 6, **caractérisé en ce que** ledit circuit d'éléments pour un filtre FIR est remplacé au moins soit par ledit circuit d'éléments de l'étage initial (115), soit par ledit circuit d'éléments d'étage final (117).

9. Circuit d'éléments pour un filtre FIR selon l'une quelconque des revendications 5 à 8, **caractérisé en ce que** lesdits coefficients desdits circuits multiplicateurs (101) sont variables.

FIG. 1

EP 1 703 636 B1

FIG. 2

FIG. 3

EP 1 703 636 B1

# FIG. 4

EP 1 703 636 B1

FIG. 5

FIG. 6

# FIG. 7

EP 1 703 636 B1

*FIG. 8*

EP 1 703 636 B1

FIG. 9

*FIG. 10*

EP 1 703 636 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 59103418 A
- EP 0948133 A